# EUROPEAN PATENT APPLICATION

(11) **EP 1 577 739 A2**
(43) Date of publication of application: **21.09.2005**
(21) Application number: 04005452.0
(22) Date of filing: 08.03.2004
(51) Int. Cl.: G06F 1/20

(54) **Cooling system for electronic apparatus, and electronic apparatus using the same**

(30) Priority: 16.02.2004 JP 2004038378
(71) Applicant: Hitachi, Ltd., Tokyo 100-8010 (JP)
(72) Inventor: Suzuki, Osamu c/o Hitachi, Ltd.,Int.Prop. Group, Tokyo 100-8220 (JP)
(74) Representative: Beetz & Partner

(57) **Abstract**

An electronic apparatus, such as personal computers of desktop type and notebook type, as well as a server, etc., having a cooling system being high in cooling efficiency, wherein a CPU (200) in need of cooling is installed within a housing (100), and the liquid cooling system for cooling the CPU, comprises: a heat-receiving (cooling) jacket (50); a radiator (60); and a circulation pump (70), wherein the heat-receiving (cooling) jacket (50), for transmitting heat generated from a heat-generation element, i. e., the CPU, into a liquid coolant flowing within an inside thereof, has a heat diffusion plate (90) attached on the lower surface thereof. This heat diffusion plate encloses an operating fluid (94), such as water, within a space, which is hermetically sealed and formed within an inside thereof, and also has heater elements (95), being provided in contact with a portion the operating fluid. To those heater elements (95) are supplied a pulse-like electric power. With this, a portion of the operating fluid repeats forming/extinguishing, to give vibration to the operating fluid, thereby diffusing the heat over the entire of the diffusion plate, thereafter the heat is transmitted to the heat-receiving (cooling) jacket. Or, alternatively, it may be connected with a heat radiation fin (300).

## Description

### BACKGROUND OF THE INVENTION

The present invention relates to an electronic apparatus, such as, a personal computer, being so-called a desktop-type or a notebook-type, or a server, etc., and in particular, it relates to an electronic apparatus having a liquid cooling system therein, being able to cool down a heat-generation element mounted within an inside thereof, such as, a semiconductor integrated circuit (IC), effectively with an aid of a liquid refrigerant or coolant, as well as, the cooling system thereof.

In order to maintain a normal operation thereof, cooling is necessary for the heat-generation element, such as, the semiconductor IC element, being mounted within an electronic apparatus, including a personal computer, of so-called the desktop-type or the notebook-type, as well as, a server, etc., and in particular, the heat-generation element, such as, a CPU (Central Processing Unit), as a representative one thereof, for example. For this reason, conventionally, such the cooling is achieved generally by using a heat transfer element, being so-called a heat sink that is formed with fins thereon, as well as a fan, being provided for sending a cooling air thereto. However, small-sizing and high integration of such the semiconductor IC element in recent years, such as the heat-generation element, brings about localization of the heat generating at the portion thereof within the heat-generation element, and also for this reason, attention comes to be paid onto a cooling system of a liquid type of using the liquid coolant therein, such as a water, for example, being high in the cooling efficiency thereof, in the place of the conventional cooling system of an air-cooling type.

Namely, with the liquid cooling system of being high in the cooling efficiency thereof, which is used in the personal computer, of s-called the desktop-type or the notebook-type, and also the server, etc., as is known from the following patent documents 1-5, for example, in general, an element being so-called by a heat-receiving (or cooler) jacket is mounted on the surface of the heat-generating element, i.e., the CPU, directly, while conducting the liquid coolant within a flow passage formed within the heat-receiving jacket, so as to transmit or convey the heat generated from the CPU to the coolant flowing within the jacket mentioned above, thereby cooling down the heat-generating element with high efficiency. Further, in such the cooling system of the liquid-cooling type, normally, a heat cycle is made up with the cooler jacket, as the heat-receiving portion thereof, and in more details thereof, it comprises a circulation pump for circulating the liquid coolant mentioned above within the cycle, so-called a radiator, being a heat-radiation portion for irradiating heat of the liquid coolant mentioned above into an outside, and further a coolant tank provided in a part of the cycle depending on the necessity thereof. And, those are connected through a tube made of a metal and/or an elastic material, such as rubber or the like.

On the other hand, conventionally, as an apparatus for diffusing (or conducting) heat generated from the heat-generation body, such as, the semiconductor element, etc. , which is installed within the electronic apparatus, there is already known a heat diffusion plate, for example, in the following patent document 6; wherein, for example, a groove or gutter is formed in a loop-like manner upon each of connection surfaces between an upper plate and a lower plate, which are made of material having high thermal conductivity, and both of those plated are piled and bonded with each other, opposing those grooves to each other, thereby forming a heat pipe in an inside thereof.

In addition thereto, in general, it is already known, with a heat transmission element for transmitting heat from the heat-generation body, that driving of fluid enclosed within an inside thereof transmits the heat. For example, in the apparatus disclosed in the following patent document 7, for the purpose of transmitting the heat from a print circuit board, on which a plural number of semiconductor elements (i.e., the heat-generation bodies), a part of the formed liquid passage comprises a means, being made up with a capillary and having a heating means in a part thereof, and the heater means heats the liquid within the capillary in the pulse-like manner, to cause bumping, thereby driving the liquidmentioned above due to a sudden or abrupt increase of pressure accompanying the vaporization when the bumping occurs. Further, regarding the principle of conducting the heat with using the vibration of liquid is described, in the details thereof, in the following non-patent document 1, for example. Also, the following non-patent document 2 discloses the structure, in particular in Fig. 10 thereof, for dispersing heat-generation of a semiconductor chip having large electric power consumption, with applying a container, which builds up the device therein for conducting the heat, with utilization of the heat pipe and/or the vibration of liquid.
Patent Document 1: Japanese Patent Laying-Open No. 2003-304086 (2003);
Patent Document 2: Japanese Patent Laying-Open No. 2003-22148 (2003);
Patent Document 3: Japanese Patent Laying-Open No. 2002-182797 (2002);
Patent Document 4: Japanese Patent Laying-Open No. 2002-189536 (2002);
Patent Document 5: Japanese Patent Laying-Open No. 2002-188876 (2002);
Patent Document 6: Japanese Patent Laying-Open No. 2002-130964 (2002);
Patent Document 7: Japanese Patent Laying-Open No. Hei 7-286788 (1995);
Non-Patent Document 1: Mamoru Ozawa, et al., "Promotion of Heat Conduction through Vibration of Liquid" pp228-235, Vo. 50 No. 530 (1990-10), Articles of Japan Machinery Academic Association (B edition); and
Non-Patent Document 2: Z. J. Zuo, L. R. Hoover and A. L. Phillips, "An integrated thermal architecture for thermal management of high power electronics", pp317-336, Thermal Challenges in Next Generation Electronic System (PROCESSINGS OF INTERNATIONAL CONFERENCE THERMES 2002), SANTA FE, NEW MACICO, USA, 13-16 JANUARY 2002.

However, with such the cooling system of liquid cooling type, according to the conventional art, which was applied in the personal computers, of so-called the desktop type and the notebook type, and the server, etc., cooling of the heat-generation body, such as, the CPU, for example, is achieved by mounting it directly on the above-mentioned heat-receiving (or cooling) jacket having high coolingeffect, however in general, the heat-generation body, i.e., the CPU comes to be small, in particular, on the surface area thereof , accompanying high integration of the semiconductor elements in recent years. On the contrary to this, the heat-receiving (or cooling) jacket has a large surface area due to the structure thereof; e.g., the liquid coolant flows within the flow passage formed within the ins ide thereof, therefore, the area is very small, upon which the heat-generation element, i. e. , the CPU is in contact with, comparing to the surface area of the heat-receiving (or cooling) jacket.

In this manner, in a case where the area is small, upon which the heat-generation body, or the CPU is in contact with, comparing to that of the heat-receiving (or cooling) jacket, the heat generated within the CPU diffused into the contact surface between the heat-receiving (or cooling jacket) and also the peripheral portion thereof, and thereafter it is conducted to the liquid coolant flowing within the jacket, thereby being discharged into an outside. However, in the case where that contact surface is small in the area thereof, even though the heat diffuses also to the peripheral portion thereof, more or less, but it cannot diffuse to the entire of the jacket, therefore the cooling efficiency of the heat-generation element is lowered by means of the heat-receiving (or cooling) jacket. Thus, at a position relatively far from the contact position with the CPU, the conduction of the heat generation cannot be obtained sufficiently, to the liquid coolant flowing within the jacket, and therefore, only a part of cooling capacity is utilized, but without using the cooling capacity, fully, by means of the heat-receiving (or cooling) jacket.

### SUMMARY OF THE INVENTION

Therefore, an object, according to the present invention, by taking the problems in such the conventional arts into the consideration, in more details, is provide a cooling system, being suitable for use in the personal computers, such as, called by the desktop type and/or the notebook type, and also the server, etc., and enhancing or increasing the cooling efficiency thereof with using a heat transmission/diffusion element, in which heat transmission/diffusion is promoted or facilitated through vibration of the heat-conductive liquid filled within an inside of a heat-conductive member, as well as, an electronic apparatus having such the cooling system therein.

Thus, according to the present invention, for accomplishing such the object mentioned above, firstly, there is provided a cooling system for an electronic apparatus, installing a semiconductor element within a housing, which necessitates cooling for maintaining normal operation thereof, in a part of the housing, having: a heat diffusion element being connected with the semiconductor element, thermally, wherein said heat diffusion element comprises: a plate-like member of heat conductive material, enclosing therein an operating liquid having large latent heat; and an actuator being provided in a part of the plate-like member, for vibrating said operating liquid having large latent heat, wherein: said heat diffusion element mounts said heat-generating semiconductor element on one side surface, while transporting heat generated from said heat-generation semiconductor element to other side surface of said heat diffusion element, thereby conducting heat transmission from said other side surface.

Also, according to the present invention, in the cooling system for an electronic apparatus as described in the above, it is preferable that a heat radiation plate is attached on the other side surface of said heat diffusion element, or that a cooling jacket is attached on the other side surface of said heat diffusion element, being thermally connected with said semiconductor element, thereby transmitting the heat generated therein to a liquid coolant vibrating within an inside of said cooling jacket, so as to conduct the cooling upon said semiconductor. Also, according to the present invention, in the cooling system for an electronic apparatus as described in the above, it is preferable that the actuator for vibrating the operating liquid filled within said heat diffusion element is made up with a heater wire wound around periphery of two (2) pieces of supporting bodies, and in particular, it is preferable that said heater wire is made from a nichrome wire. Further, according to the present invention, in the cooling system for an electronic apparatus as described in the above, it is also preferable that said actuator made up with the heater wire wound around the periphery of said two (2) pieces supporting bodies is disposed within an inside of said plate-like member, so that it dips in said operating fluid filled therein, near to said other surface thereof, or that hydrophilic treatment is conducted on a portion, on a surface of interior wall of said one side surface in said plate-like member, in vicinity of said actuator.

Next, according to the present invention, for accomplishing such the object mentioned above, there is provided an electronic apparatus, installing a heat-generating semiconductor element within a housing thereof, which requires cooling for maintaining normal operation there, and having a cooling system, within said housing or in a part thereof, comprising: a cooling jacket, being thermally connected with the semiconductor element, for transmitting heat generated from to a liquid coolant flowing within an inside thereof; a radiator for discharging the heat transmitted to the liquid coolant in said cooling jacket into an outside; and a circulation pump for circulating said liquid coolant in a loop, including said cooling jacket and said radiator therein, wherein: said cooling jacket is in contact with a surface of said heat-generating semiconductor element through a heat diffusion means for diffusing the heat generated from said heat-generating semiconductor element.

And, according to the present invention, in the electronic apparatus descried in the above, it is preferable that said heat diffusion means for diffusing the heat generated from said heat-generating semiconductor element into said cooling jacket comprises a hermetically sealed space for enclosing an operating fluid having large latent heat to be vibrated within an inside thereof, and is made up with a plate-like member having a surface shape being almost similar to that of said cooling jacket and being superior in heat conductivity, wherein an actuator is provided in a portion thereof, for vibrating said operating fluid, while dipping in said operating fluid. Also, according to the present invention, in the electronic apparatus descried in the above, it is preferable that in a part of said hermetically sealed space of said heat diffusion means, into an inside of which is enclosed the operating fluid having the large latent heat to be vibrated, is provided a buffer portion for enclosing a gas therein. Further, according to the present invention, in the electronic apparatus descried in the above, it is preferable that said hermetically sealed space of said heat diffusion means, into an inside of which is enclosed the operating fluid having the large latent heat to be vibrated, are formed in a plural number thereof and in parallel with each other, and also each of those is connected through said buffer portion, thereby forming a comb-like shape. And, also according to the present invention, in the electronic apparatus descried in the above, it is preferable that said heat diffusion means comprises a heating means provided in contact with a part of the operating fluid enclosed within said hermetically sealed space, and-said heating means is supplied with pulse-like electric power, thereby providing vibration to said operating fluid.

Further, according to the present invention, for accomplishing such the object mentioned above, there is also provided an electronic apparatus, installing a heat-generating semiconductor element within a housing thereof, which requires cooling for maintaining normal operation there, and having a cooling system, within said housing or in a part thereof, comprising: a heat diffusion element, being connected with said semiconductor element, thermally; and a heat radiator, wherein said heat diffusion element comprises: a plate-like member of heat conductive material, enclosing therein an operating liquid having large latent heat; and an actuator being provided in a part of the plate-like member, for vibrating said operating liquid having large latent heat, whereby said heat diffusion element mounts said heat-generating semiconductor element on one side surface, while diffusing heat generated from said heat-generating semiconductor element, thereby transmitting the heat to the other side surface of said heat diffusion element; and said heat radiation plate is attached on the other side surface of said heat diffusion element, and transmitting the heat generated from said heat-generating semiconductor element, which is transported through said heat diffusion element, from a surface thereof into an outside.

### BRIEF DESCRIPTION OF THE VARIOUS VIEWS OF THE DRAWING

Those and other features, objects and advantages of the present invention will become more apparent from the following description when taken in conjunction with the accompanying drawings wherein:
Fig. 1 is a partially exploded perspective view, for showing an example, in particular, the detailed structures of a heat receiving jacket and a heat diffusion plate, in a cooling system of an electronic apparatus, according to the present invention;
Fig. 2 is a perspective view for showing the cooling system, in particular, of an electronic circuit portion, in the electronic apparatus, according to the present invention;
Fig. 3 is a partially exploded perspective view, for showing an example of disposition of each part, within an inside of a desktop-type personal computer, for example, in which the cooling system motioned above is installed therein;
Fig. 4 is a partially enlarged perspective view for showing an example of a heater element, which is provided within an inside of each of a plural number of grooves, which are formed within the heat diffusion plate mentioned above;
Fig. 5 is a partially enlarged perspective view for showing the above-mentioned groove and the heater element provided within the inside thereof, for explaining the principle of heat diffusion by means of the heat diffusion plate mentioned above;
Fig. 6 is a cross-section view for showing the heat diffusion plate, the heat-receiving jacket and a CPU, for explaining the principle of heat diffusion by means of the heat diffusion plate mentioned above;
Fig. 7 is a perspective view for showing the structure, in particular, of the heat diffusion plate mentioned above, but according to other embodiment, in the cooling system of the electronic apparatus according to the present invention;
Figs. 8(a) and 8(b) are a cross-section view and an upper view, for showing the structure of the heat diffusion plate mentioned above, according to further other embodiment, in the cooling system of the electronic apparatus according to the present invention;
Fig.9 is an upper view for showing the structure of the heat diffusion plate mentioned above, according to further other embodiment, in the cooling system of the electronic apparatus according to the present invention;
Fig. 10 is also an upper view for showing the structure of the heat diffusion plate mentioned above, according to further other embodiment, in the cooling system of the electronic apparatus according to the present invention;
Fig. 11 is an enlarged cross-section view of a portion, wherein the heater element is disposed within the heat diffusion plate (or a heat spreader), according to other embodiment of the present invention;
Figs. 12 (a) and 12 (b) are an upper view and a side view for showing the detailed structure of the heater element mentioned above;
Fig. 13 is a partially enlarged cross-section view, for explaining the operation of the heat diffusion plate (i.e., the heat spreader), according to the other embodiment mentioned above;
Figs. 14(a) and 14 (b) are a side view and a perspective view for showing a variation of the heater element mentioned above;
Fig. 15 is a partiallyenlargedcross-sectionviewfor showing further variation of the heater element mentioned above;
Fig. 16 is also a partially enlarged cross-section view for showing further other variation of the heater element mentioned above;
Fig. 17 is a side surface cross-section view for showing the cooling system of the electronic apparatus, using the heat diffusion plate therein, according to other embodiment of the present invention;
Fig. 18 is also a side surface cross-section view for showing the cooling system of the electronic apparatus, using the heat diffusion plate therein, according to other embodiment of the present invention; and
Fig. 19 is an upper view of the cooling system of the electronic apparatus, using the heat diffusion plate therein, i.e., seen from a direction "c" shown in Fig. 18 mentioned above.

### DETAILED DESCRIPTION OF THE INVENTION

Hereinafter, explanation will be given on the embodiments according to the present invention, in details thereof, by referring to the drawings attached herewith.

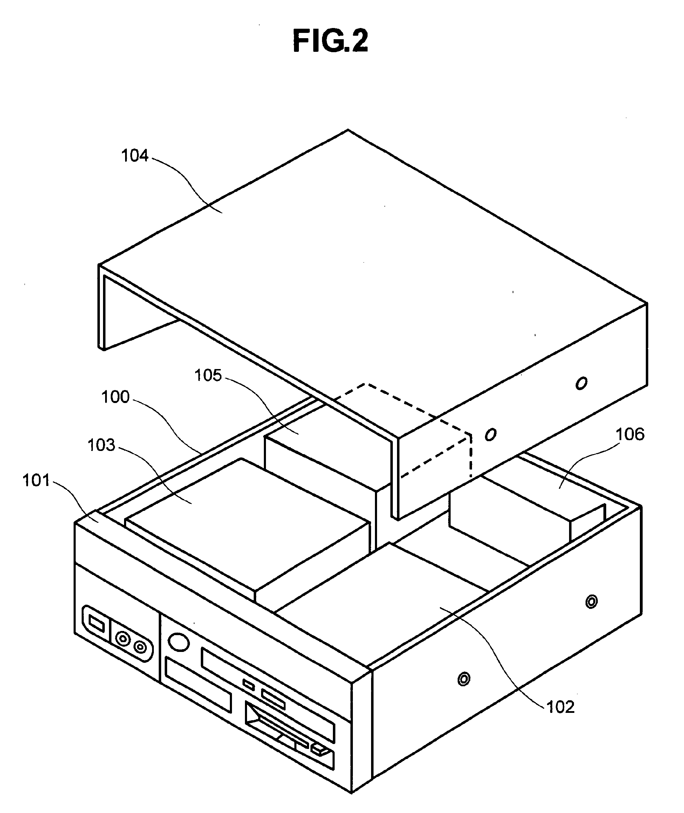

First of all, Fig. 2 attached herewith shows an example of the entire structure of an electronic apparatus having a liquid cooling system therein, according to one embodiment of the present invention. However, in this embodiment is shown a case, where the present invention is applied into a main portion of a personal computer, such as, of so-called the desktop type, for example.

As shown in the figure, the main portion of the desktop type personal computer comprises a housing 100, which is formed from a metal plate into a cubic shape thereof, for example, and on a front panel portion 101 thereof are provided various kinds of switches; including an electric power switch and so on, and also indicator lamps, etc. Also, within an inside thereof is disposed a driver device 102, for driving various kinds of external information recording medium, such as, a floppy disk, a CD, and a DVD, etc., so that it positions an opening thereof on the front panel portion 101. Also, a reference numeral 103 in the figure depicts a memory portion provided within the housing 100 mentioned above, comprising a hard disk device, for example. And also, a reference numeral 104 in the figure depicts a cover to be put on the housing 100 mentioned above.

While on a rear side of the housing 100 is disposed an electronic circuit portion 105, having a liquid cooling system according to the present invention, and a reference numeral 106 in the figure depicts an electric power source portion for supplying from a commercial electric power source, a desired electric power to each of the portions, including, the driver device 102, the memory portion 103, and the electronic circuit portion 105 mentioned above.

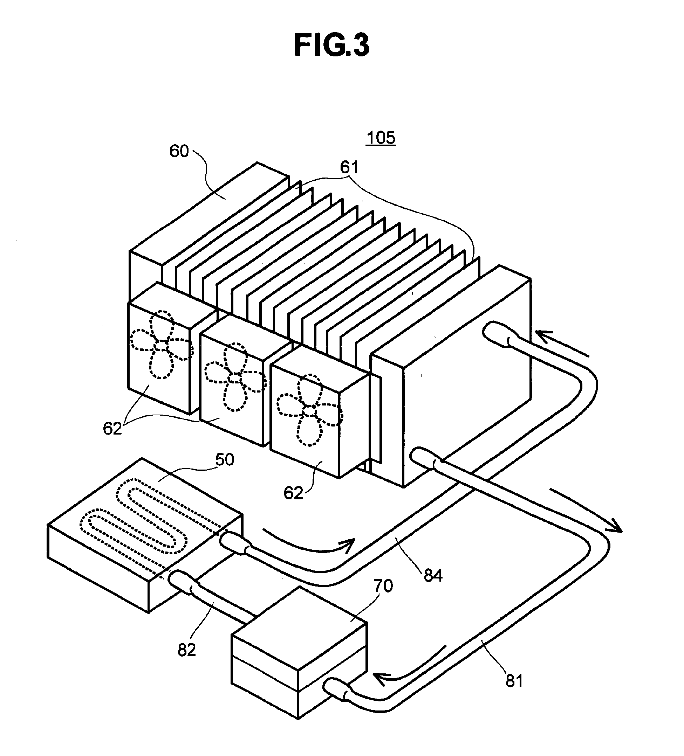

Next, in Fig. 3 attached herewith is shown the electronic circuit portion 105 of the electronic apparatus, the brief structure of which was explained in the above; i.e., within the desktop type personal computer, in particular, mainly around a heat receiving jacket 50 for mounting thereon a heat-generation element, such as, a CPU, as a main or principle structure thereof. However, in this embodiment, a chip 200 of the CPU, being such the heat-generation element as was mentioned, is mounted on the lower side surface of the heat-receiving jacket 50 mentioned above, being in directly contact with, therefore it is not illustrated on the figure, herein.

And, as is apparent from the figure, this electronic circuit portion 105 comprises the above-mentioned heat-receiving (or cooling) jacket 50 for mounting the CPU thereon, a radiator portion 60 for radiating heat generated from the CPU into an outside of the apparatus, a pump 70 for building up a cooling system, and further flow passages are formed by connecting tubes (conduits) 81, 82..., being made of a metal, or an elastic material, such as a rubber or the like, being covered with a metal film, etc. on the outer surface thereof, so as to prevent the liquid coolant inside from leaking outside, for conducting a liquid coolant (for example, a water, or a water mixed with a so-called anti-freezing solution, such as, propylene glycol, at a predetermined ratio) to each of those portions building up the heat cycle. Also, in a part of the radiator portion 60 mentioned above, there are attached with plate-like shaped fans 62, 62... (in a plural number, such as, three (3) pieces, in the present example), directing into an outside of the apparatus, for blowing wind onto a large number of fins 61, as the constituent element of the radiator portion, thereby radiating the heat transmitted from the heat receiving jacket 50 mentioned above, compulsively.

Namely, as apparent from the figure, the radiator portion 60 mentioned above is connected to the circulation pump 70 by means of the tube (conduit) 81, and is further connected to the heat-receiving jacket 50 through the tube (conduit) 82, thereafter is connected to the radiator portion 60 mentioned above, thereby forming a loop turning back thereto. Namely, with an aid of operation of the circulation pump 70, within the liquid circuit mentioned above circulates the above-mentioned water, or the mixture thereof with the anti-freezing solution, as the liquid coolant.

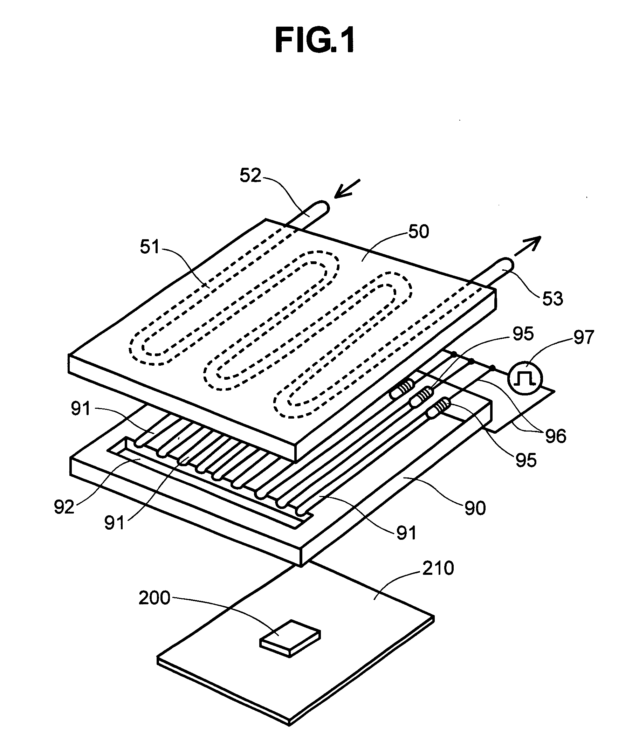

And, in Fig. 1 attached herewith, there is shown the detailed structure of the heat-receiving jacket 50 mentioned above, together with a heat diffusion plate (the heat spreader) 90 attached on the lower surface thereof. As is apparent from this figure, the heat-receiving jacket 50 is made of a plate-like member of material, having high heat conductivity, such as a metal, etc., including, copper or aluminum therein, for example, and in an inside thereof is formed a flow passage 51, winding around, for example, in the present embodiment, so that the liquid coolant can flow covering over the entire thereof. Also, reference numerals 52 and 53 in the figure depict an inlet and an outlet for guiding and discharging the liquid coolant into/from the heat-receiving jacket 50, respectively.

On the other hand, the heat diffusion plate (the heat spreader) 90 is also made of a plate-like member, being made of a metal, etc., having high heat conductivity, and as is apparent from the figure, so as to be in contact with the lower surface of the heat-receiving jacket 50 mentioned above, it has a surface being same to that of the jacket 50 in the form/sizes thereof. And, on this heat diffusion plate 90, for example, on a surface thereof in contact with the heat-receiving jacket 50, in the example shown in the figure, are formed a plural number of grooves (or gutters) 91, 91..., having a circular or rectangular shape in the cross-section thereof and being minute in the cross-section area (for example, around several mm²) thereof, in parallel with one side thereof, and further each of the plural number of those grooves 91 is connected to a common groove or gutter 92, which is formed at one end portion thereof (i.e., the left-lower side in the figure), to be so-called a buffer portion, respectively. Namely, attachment and fixation of this heat diffusion plate 90 onto the lower surface of the heat-receiving jacket 50 defines a comb-like hermetically sealed space within an inside thereof, with the plural number of the passages 91, 91... and the buffer portion 92. Further, in that instance, grooves or gutters 91, 92 may also formed on the lower surface side of the heat-receiving jacket 50, being similar to those mentioned above, to be located opposing to each other when they are bonded together. Also, among of those closed spaces, in particular, within an inside of each of those passages 91, 91... is enclosed a fluid (i.e., an operation fluid 94), having a large latent heat, such as, a water (i.e., pure water) or the like, representatively, for example, though will be explained in more details thereof, hereinafter.

Also, at the other end portion thereof (i.e., the right-upper portion in the figure), so-called heater elements 95, 95... are disposed, respectively, to build up heating members, the details of which will be explained hereinafter. In the figure, there is also shown conductor lines 96, for supplying the pulse-like heating electric power to those heater elements 95, 95..., and also a pulse electric power generating circuit 97. And, as was mentioned in the above, the heat-receiving jacket 50, being assembled together with the heat diffusion plate 9 0 in one body is attached, for example, on the CPU 200; i.e., the heat-generation element mounted on the printed circuit board 210, as shown in this figure, so as to be in contact with the surface of the CPU.

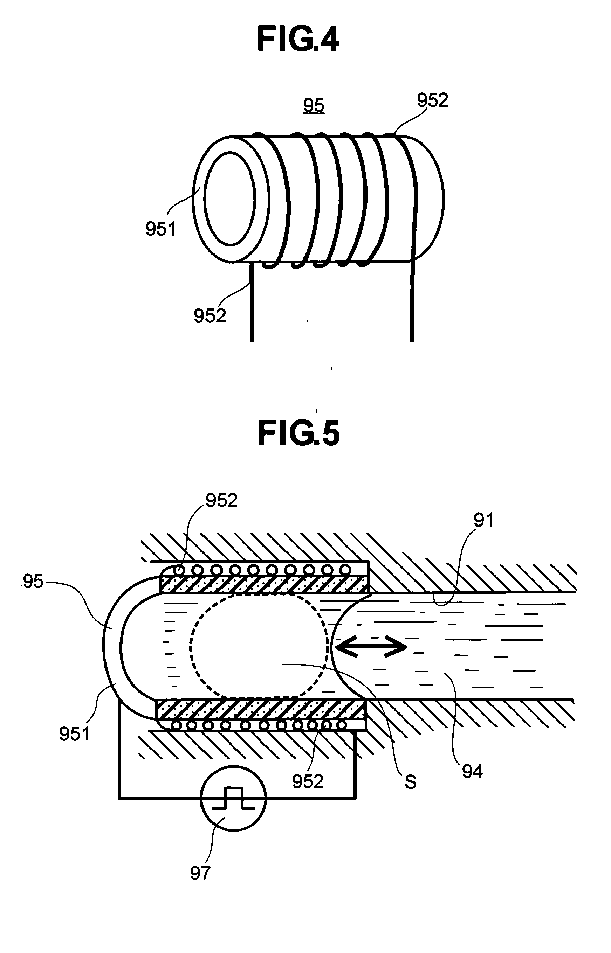

Fig. 4 attached herewith shows an enlarged view about the heater element 95, which is attached at the other end portion of each of the plural number of the passages 91, 91..., which are formed within an inside of the heat diffusion plate 90 mentioned above. Thus, this heater element 95 is built up with a cylindrical member (i.e., a bobbin) 951 made of an inorganic material, such as ceramic, for example, while being wound thereroung helically with a fine wire 952 (for example, about 0.1 mm in diameter), such as, a nichrome wire or a stainless wire, etc., for example, and thereafter being fixed through treatment of a coating or the like, on the surface thereof. Or, in case of forming the cylindrical member (bobbin) 951, to be the supporting body of the fine wire, from the material having electric conductivity, such as a metal or the others, for example, it is preferable to cover the surface thereof with an inorganic material of electric insulator at first. This is because of preventing it from change thereof, due to contacting with the water and other organic materials (for example, propylene glycol, etc., as the anti-freezing solution), filled within the passage formed within an inside thereof as the operating fluid 94.

Also, charging of the operating liquid 94 mentioned above is conducted, by injecting the liquid coolant, such as the water, etc. , as the operating fluid 94, into an inside of the plural number of passages 91 mentioned above, for example, when bonding the heat diffusion plate 90 mentioned above with the heat-receiving jacket 50 in one body. Alternatively, though not shown in the figure herein, however with provision of a communicating port between the passages 91 and the surface of the heat-receiving jacket 50, it is possible to charge the operation fluid 94 therefrom. However, upon charging of the operating fluid 94 therein, charging pressure is altered depending upon the characteristics of the operating fluid, or a gaseous phase portion of non-condensation gas (for example, an air) is mixed therein when charging it.

Next, Fig. 5 attached herewith shows the cross-section view, for showing the other end portion thereof, i.e., a portion of the heat diffusion plate 90 mentioned above, where the heater element 95 buildingupthedrivingmeans of the operating fluid 94 is attached, within the passage 91 formed within the inside thereof. Further, as was shown in the above, on the heater element 95, made up with the fine wire 952 of the nichrome wire, etc., is formed wirings for supplying the heat-generation electric power thereto, and through those wirings, the electric power from the pulse-like electric power generating circuit 97 is supplied to the heater element 95 mentioned above, intermittently, and in a pulse-like manner. In this instance, the pulse frequency is, for example, in about from several tens to several hundreds Hz, but depending upon the sort of the operating fluid 94 and the sizes of the passages 91. Also, with such a pulse-like electric power supplying means, it may be formed, for example, in a part of the heat diffusion plate 90 in a form of an electronic circuit, or on the printed circuit board 210 mentioned above, and further, it may be built up, with using a portion of the CPU 200 mounted on the printed circuit board 210. Though not shown in the figure herein, however it is also possible to use a portion thereof, from an electric power source supplying driving electric power to the CPU 200, and such the structure may be advantageous from a viewpoint of simplification of the circuit.

Following to the above, explanation will be made about the conducting (or diffusing) function of heat in the heat diffusion plate (i.e., the heat spreader) 90, the structure of which was explained in the above, by referring to Fig. 5 mentioned above.

First, when the electric power is supplied in pulse-like manner from the pulse-like electric power generating circuit 97 mentioned above, it is converted into heat on the nichrome fine wire 952 of the heater element 95 shown in Fig. 5 mentioned above. Due to this pulse-like heat, the operating fluid 94 within the passages 91 (for example, the water in the present example) is headed suddenly or abruptly (i.e., in the pulse-like manner), and with this, it evaporates or vaporizes (causing the pumping), thereby generating a bubble S due to the vapor thereof, within an inside of the heater element 95 and the vicinity thereof, i.e., in a portion in an inside of the operating fluid 94. Thereafter, when the pulse-like electric power stops to be supplies thereto, the heating by means of the nichrome fine wire 952 also stops, thereby extinguishing the vapor 4a of the operating fluid generated in the above.

In this manner, with supplying of the pulse-like electric power mentioned above, continuously, to the nichrome fine wire 952 building up the heater element 95, the operating fluid 94 enclosed in the inside at the end portion of the passage 91 (i.e., at the position where the heater element 95 is provided) repeats the generation and extinction of the bubble 94a due to the generation and extinction of the vapor thereof. And, at the time when this bumping occurs due to the abrupt increase of pressure accompanying the vaporization thereof, and also expansion of the bubble accompanying therewith, the operating fluid 94 is vibrated with the vibration generated. Namely, accompanying the vibration of the operating fluid 94 within the passage 91, the heat from the CPU 200 mentioned above is transmitted/diffused on a plane thereof, first with the function of this heat diffusion plate (i.e., the heat spreader) 90.

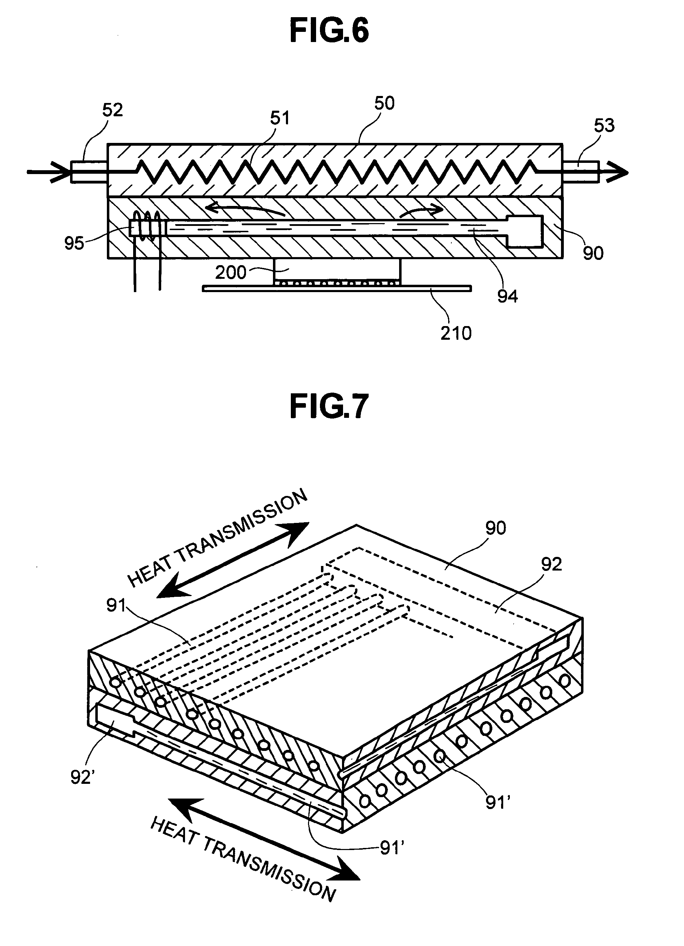

Namely, as is shown in Fig. 6 attached herewith, the heat generated in the CPU 200, i.e., the heat-generation element, is transmitted/dif fused on the plane, with an aid of the heat diffusion plate (i.e., the heat spreader) 90, at least covering over the sufficient area comparing to the surface of the CPU 200 mentioned above, and thereafter, it is transmitted into the heat-receiving jacket 50 and also into the liquid coolant flowing in the flow passage 51 within an inside thereof, thereby being discharged into an outside. In this instance, as was mentioned in the above, due to the function of the heat diffusion plate 90, the area of transmitting the heat generated from the CPU 200 to the heat-receiving jacket 50 is increased, remarkably, in other words, the heat can be widely dif fused over the entire of the heat-receiving jacket 50, and for this reason, the cooling efficiency of the heat-generation element is improved up by means of the heat-receiving (or cooling) jacket. Namely, even at the position relatively far from the contacting position with the CPU, the heat-generation can be transmitted to the liquid coolant flowing within the heat-receiving jacket, therefore enabling to fully utilize the cooling capacity by means of the heat-receiving (or cooling) jacket. And, such the cooling system is suitable to be used in the personal computers, such as being called by the desktop type and the notebook type, and also the server, etc., and for this reason, by attaching the heat diffusion plate (i.e., the heat spreader) thereto, it is possible to provide an electronic apparatus having a cooling system therein, increasing the cooling efficiency, further, with utilizing the heat-receiving (or cooling) jacket, fully.

However, with the embodiment mentioned above, in particular, the heat diffusion plate (i.e., the heat spreader) 90, it was explained that the fine wire 952 building up the heater element 95 thereof is made from the nichrome wire, in particular, because of the excellent characteristics thereon, when generating the bubble within the operating fluid 94 through heating due to the pulse-like electric power thereto, however in the place of the structure thereof, for example, the heater element 95 may be made, by laminating a film of, such as, polysilicon or tantalum compound (TaN), etc., for example, through an insulation film (such as, SiO₂ layer), i.e., in the form of a resistor film.

Following to the above, Fig. 7 attached herewith shows the structure, in particular, of the heat diffusion plate (i.e., the heat spreader) according to other embodiment, in the electronic apparatus having the cooling system according to the present invention. Namely, as is apparent from this figure, according to the other embodiment, an upper layer having the passages 91, the buffer potions 92 and the heater elements 95, which build up the heat diffusion plate 90 mentioned above, is piled up on a lower layer (having the passages 91', the buffer potions 92' and the heater elements 95') into two(2)-layer structure, and also the passages 91, 91' are formed in the directions being orthogonal to each other. With such the structure, as indicated by arrows in the figure, the heats generated in the CPU 200, i.e., the heat-generation element, diffuse covering the entire directions on the plane, with crossing each other at the right angle, thereby being transmitted to the entire of the heat-receiving jacket 50 mentioned above. Namely, also with more fully utilizing the heat-receiving (i.e., cooling) jacket, which is applied into the personal computers, such as being called by the desktop type and the notebook type, and also the server, etc., it is possible to achieve more effective cooling, as the cooling system further increasing the cooling efficiency thereof.

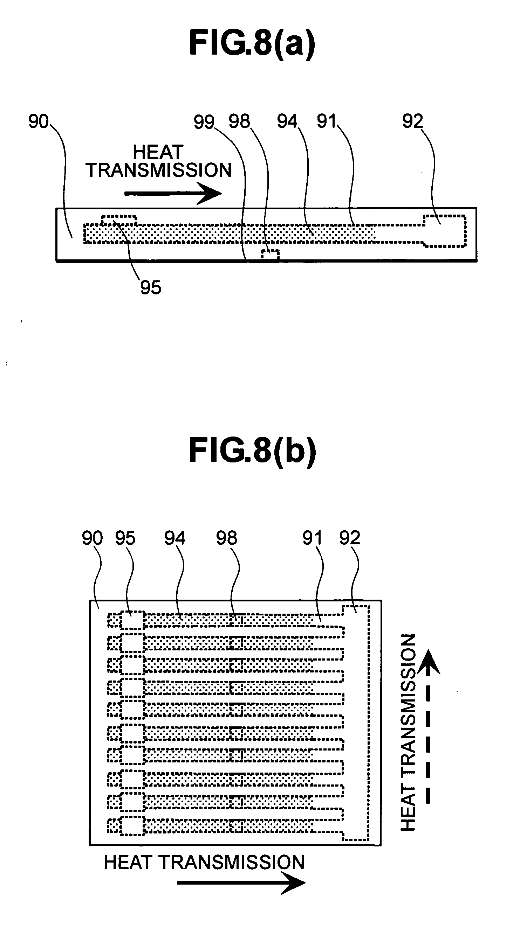

Next, Figs. 8(a) and 8(b) attached herewith shows the structure of the heat diffusion plate (i.e., the heat spreader) 90, according to further other embodiment of the present invention. Thus, in the further other embodiment, in the vicinity of a lower surface of the heat diffusion plate (i.e., the heat spreader) 90 are provided a plural number of temperature sensors 98, 98..., and also the operating fluid 94 within each of the passages 91, which build up the heat diffusion plate 90, is driven/operated individually, in the structure thereof.

Namely, in the heat diffusion plate (i.e., the heat spreader) 90, according to this further other embodiment, the pulse-like electric power supplying circuit 97 detects a location of an increase of temperature upon the lower surface 99 of the heat diffusion plate 90, with using temperature detection signals from those temperature sensors 98, which are disposed within the substrate of the heat diffusion plate 90 mentioned above, and controls the driving electric power to be supplied to the heater element 95 provided in each of the passages 91, selectively. Thus, in the heat diffusion plate 90, the pulse-like electric power is supplied to (or drive) only the heat element 95 of the passage 91 corresponding to the portion where the temperature rises up locally. With this, it is possible to promote or enhance the heat transmission (or diffusion), not upon the entire of the heat diffusion plate, but only at the necessary portion thereof, thereby achieving the heat diffusion plate (i. e. , the heat spreader) having an efficiency being much higher.

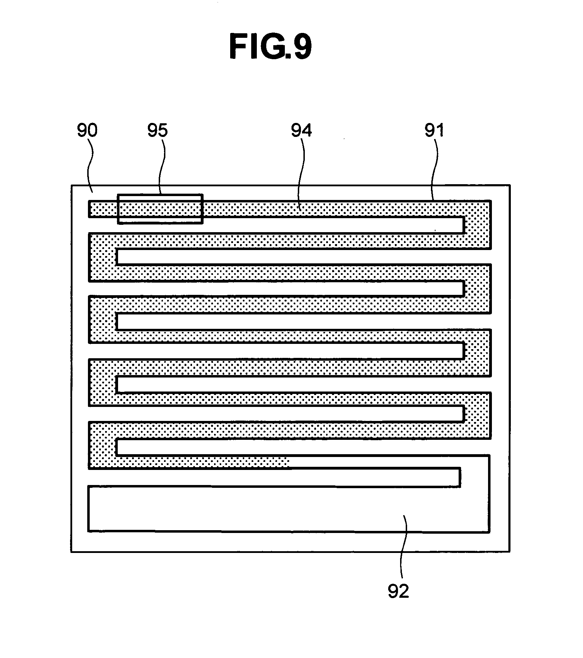

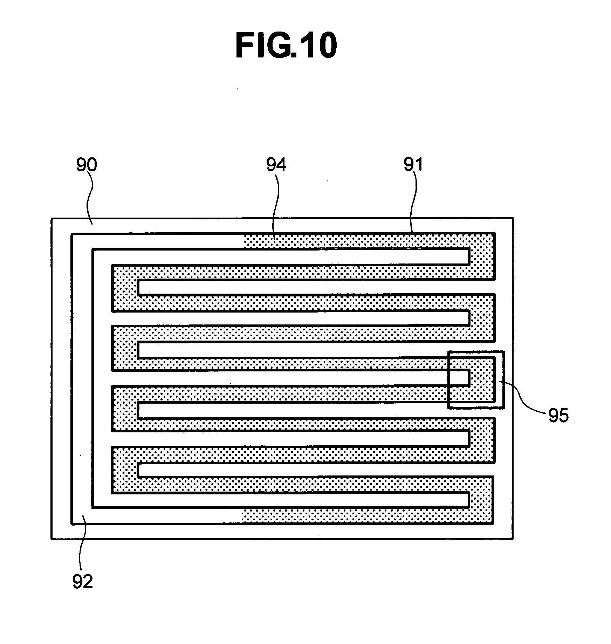

Next, Figs. 9 and 10 attached herewith show further other structure of the heat diffusion plate (i.e., the heat spreader) 90, according to the embodiment of the present invention. Thus, in an example shown in Fig. 9, it is the heat diffusion plate 90, wherein the passage 91 mentioned above is formed, not in the plural number thereof, but only one (1) piece of the groove or gutter, and further the groove is wound around in the zigzag manner over the entire surface of the heat diffusion plate. However, as shown in the figure, the heater element, being the means 95 for driving the operating fluid 94 within the passage 91 (i.e., the actuator), it is provide at the upper left-hand side in the figure, and on the contrary to this, the buffer portion 92, in which the non-condensation gas, such as, the air is enclosed therein, is formed on the opposite side (i.e., a lower side in the figure) to the position where this heater element 95 is formed.

Also, in an example shown in Fig. 10, also the passage 91 formed is made up with one (1) piece of the groove, and is wound around in the zigzag manner over the entire surface of the heat diffusion plate, however both ends thereof are connected with each other, therefore coring a ring-like shape as a whole. However, in the example of this figure, the heater element 95 building up the driving means is provided at a central portion on the right-hand side in the figure, and the buffer portion 92 at the opposite position to that where this heater element 95 is formed (i.e., the left-hand side in the figure).

Namely, in the other example about the passage 91 formed within the heat diffusion plate (i. e. , the heat spreader) 90, the groove making up the passage 91 is one (1) piece, and the heater element 95 for building up the driving means is also only one (1) piece, therefore it can be manufactured easily, and is suitable, in particular, for the heat diffusion plate (i.e., the heat spreader) being relatively small in sizes and cheap.

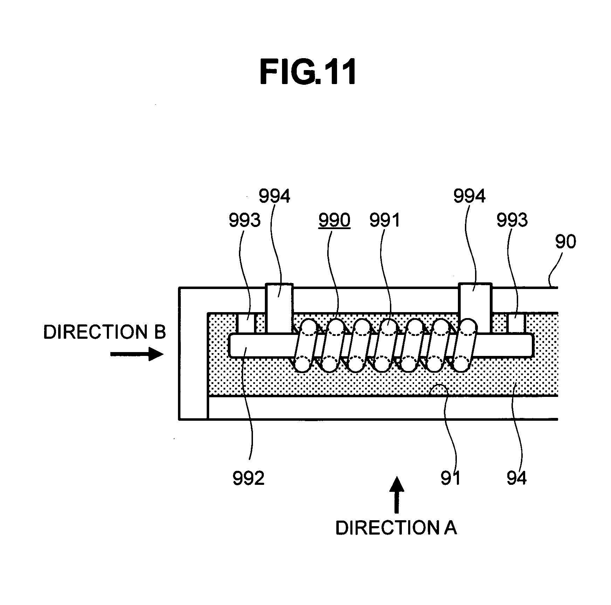

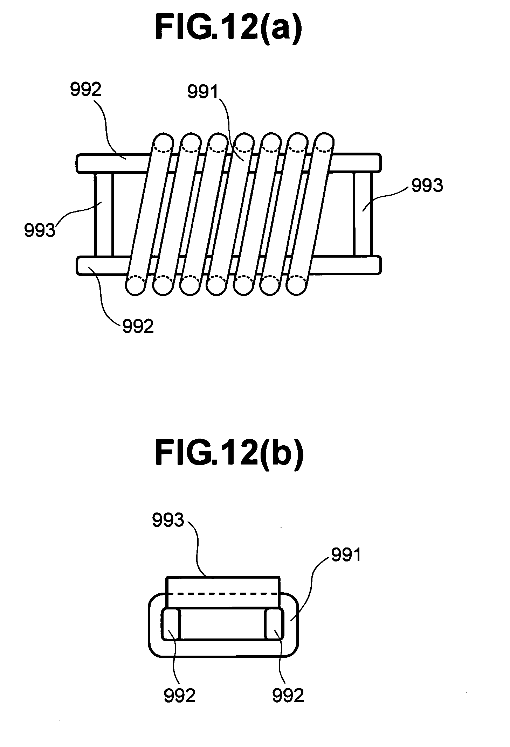

Next, Figs. 11 and 12 attached herewith shows, in particular, an enlarged cross-section view of a portion where the heater element is disposed, in the heat diffusion plate (i.e., the heat spreader) according to other embodiment of the present invention. Namely, with the heat diffusion plate (i.e., the heat spreader) 90 according to this other embodiment, for example, the heater element 991 is formed, by winding the fine wire 991 of nichrome or stainless of diameter about 0.1 mm, around the periphery of a pair supporting bodies 992 and 992 made of an inorganic material, such as a ceramic, aligning in parallel with, as is apparent from Figs. 12(a) and 12(b), thereby forming it to be plate-like in an outlook thereof. Thus, for the heater element 990, it is preferable to be formed, so that it has a large heat transmission area (i.e., the surface area) but small in the heat capacity thereof in the structure. Also, a reference numeral 993 depicts supporting bodies for supporting the pair of supporting bodies 992 and 992 mentioned above at both ends thereof, and also for attaching the heater element 95 at a predetermined position, within an inside of the groove 91 formed in the heat diffusion plate 90, and a reference numeral 994 electrodes. Further, for the purpose of lessening the heat leakage from the heater element 990 mentioned above, it is preferable to build up the supporting bodies 993, being as small as possible in the cross-section area thereof, and also with a member having a small heat conductivity.

Also, as is apparent from Fig. 11 mentioned above, the heater element 990 formed to be about a plate-like form is disposed at a position within an inside of the groove 91, so that the distance from the lower surface on the figure (i.e., the surface on the side where the heat is transported/discharged into an outside) is greater than that from the upper side on the figure (i.e., the side surface upon which the heat-generation element is in contact with), and also in parallel with those surfaces. Further, so-called the hydrophilic treatment is conducted on a portion of wall surface of the groove 91, in particular, the portion opposing to the heater element 990, for example, through roughing, etc. Further, a reference numeral 94 also indicates the operating fluid 94 filled within the inside of the groove 91 mentioned above, and as is clear from this figure, this heater element 990 is also disposed in an inside of the groove 91 dipping within the operating fluid 94 filled therein.

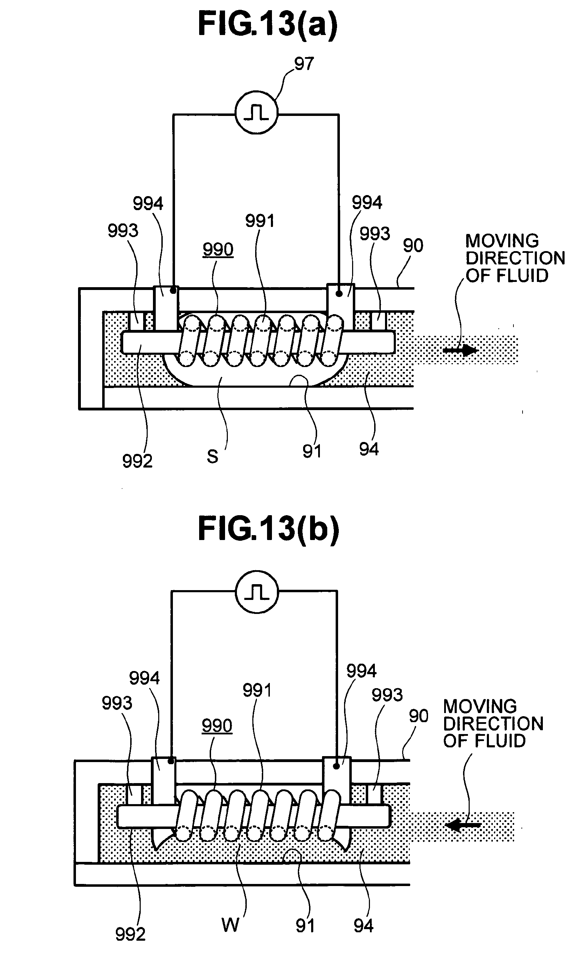

Next, Figs. 13(a) and 13(b) attached herewith show the condition where the heater element 990 mentioned above is supplied with the pulse-like electric power, to be driven therewith.

First, Fig. 13(a) shows the conditionwhere the heater element 990 conducts the electricity through it, and because of the heat-generation of the heater element due to this electric conduction, a portion of the water, i.e., the operating fluid 94 contacting with this is boiled, abruptly, and due to the pressure by the gas (i.e., the vapor) S generated, the operating fluid 94 filled within the inside of the groove 91 moves (or be pushed out) in the direction indicated by an arrow in the figure.

On the other hand, Fig. 13(b) shows the condition when the heater element 990 is in non-conductive of electricity, and accompanying this electric non-conduction, temperature of the heater element 990 comes down abruptly. At this instance, the vapor S generated in the above condensed, thereby turning back to the liquid (W), in a cooling porting at least of a temperature level lower than that of the heater element 990, thereby steadily taking the heat therefrom; i.e. , on an interior wall surface on the lower surface shown in the figure (i.e., the side surface for transporting/discharging the heat into an outside). In this instance, because of extinction of the vapor S, the operating fluid 94 filled within the inside of the groove 91 is moved (or turned back) in the direction indicated by an arrow in the figure. Namely, repetition of the operations mentioned above give the vibration onto the operating fluid 94.

However, in this instance, it can be considered that the operating fluid, i.e., the water will not turn back to the liquid (W), completely, after turning to the vapor S once, therefore this remains in the vicinity of the heater element in the form of the bubble. For this reason, it is desirable that the position of the heater element 990 be set at the position, appropriately, confirming through an experiment or the like, so that the heating surface thereof comes to be in contact with the condensed liquid (W) with certainty. Also, as mentioned above, if the hydrophilic treatment is conducted, through such as, the roughing, etc., on a portion of the wall surface of the groove 91, the liquid (W) can be condensed on that portion, easily. For this reason, it is preferable to conduct such the hydrophilic treatment on the surface of the heater element 990 (in particular, the heater wire), too.

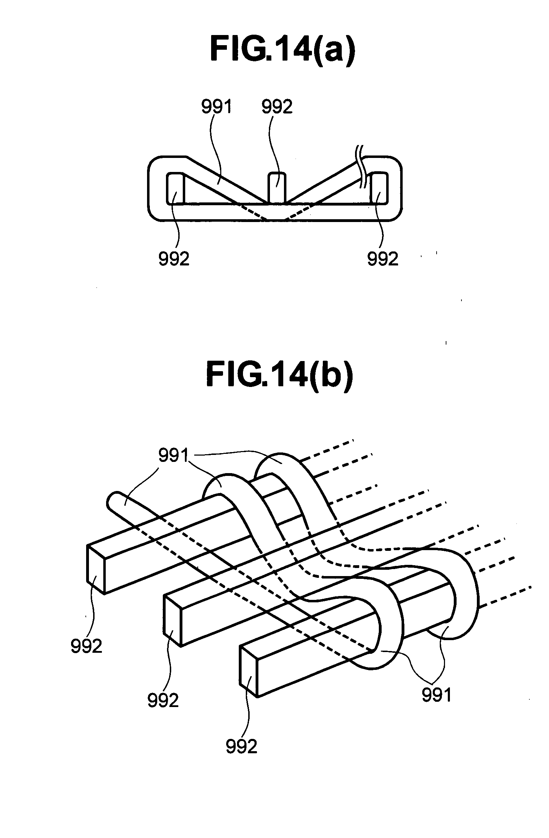

Next, Fig. 14 attached herewith shows a variation (i.e., other structure of the heater element mentioned above. Namely, as is apparent from the figure, this example is formed, with useing three (3) pieces of supporting bodies 992 therein, wherein the heater wire 991 is wound around between the pair of supporting bodies 992 located on both sides, in a plural number of times, and thereafter, by means of the remaining supporting body 992, the heater wire 991 in the central portion is pushed downward in the figure. With such the structure, it is possible to locate a large portion of the heating surface of the heater element 990 as near as possible to the cooling portion (i.e., the interior wall surface in the lower side in the figure, in an inside of the groove 91),thereby increasing the contact area between the heater element 990 and the condensed liquid (W). In other words, it is possible to accomplish the drive (i.e., vibration) of the operating liquid 94 through the heater element 990, with certainty much more.

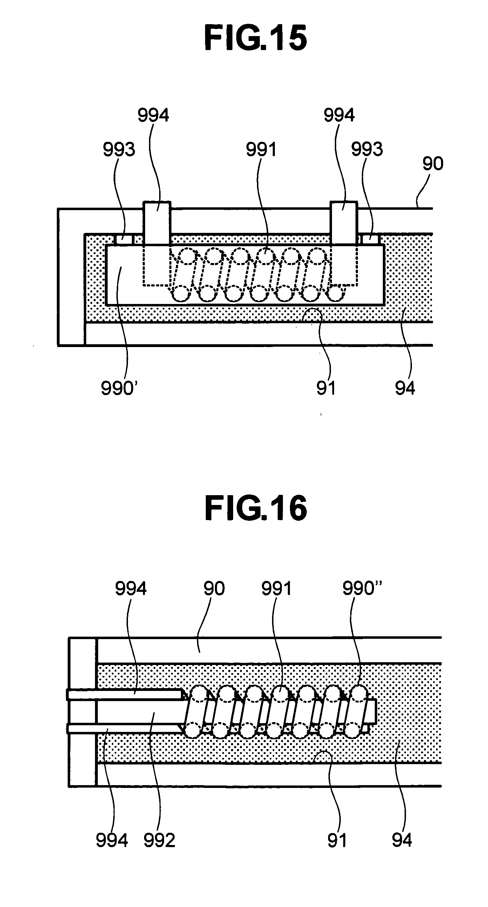

Also, Fig. 15 attached herewith shows the structure, wherein the heater element is received within the inside of a member made of a material, being small in the heat capacity and having high heat conductivity capacity thereof, and further Fig. 16 attached herewith the structure, wherein the heater element 990" is formed by winding the heater wire 991, being made from the fine wire of nichrome or stainless, too, around the periphery of a rod-like supporting body 992. However, the heater element 990" having the structure shown in Fig. 16 is inserted from an opening portion formed on a sidewall of the heat diffusion plate 90 mentioned above.

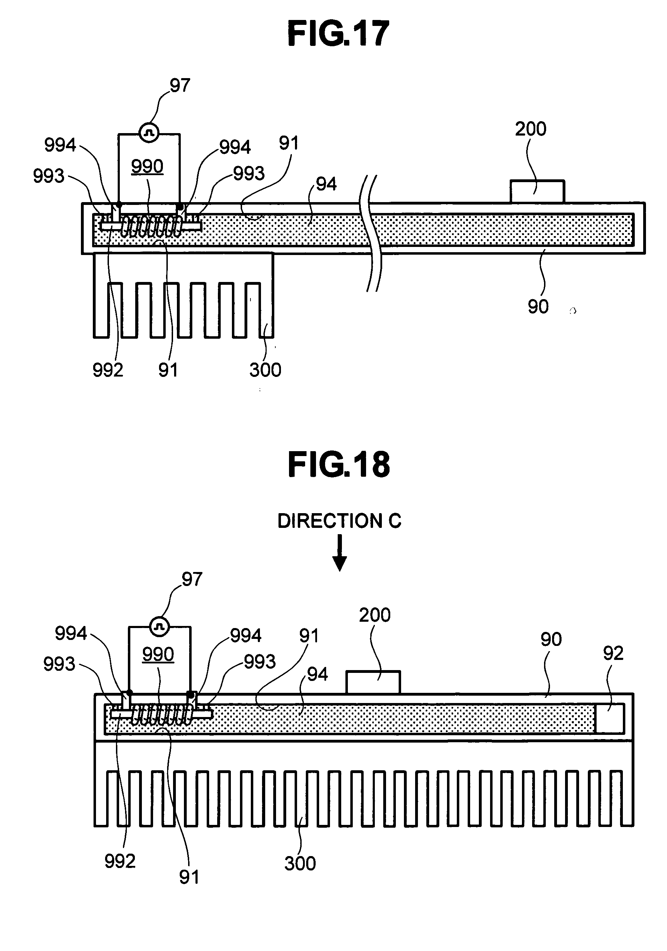

Following to the above, Fig. 17 attached herewith shows the cooling system for the electronic apparatus, according other embedment of the present invention, and in this embodiment, without using the liquid cooling system mentioned above, but upon a surface on one side of the heat diffusion plate 90, the detailed structure of which was explained in the above is attached the CPU, i.e., the heat-generation element, while on a surface of other side is attached a heat radiation plate (i.e. , a heat radiation fin) 300. Also with such the structure, the heat generated in the CPU 200 is transported to the heat radiation fin 300 with an aid of the function of the heat diffusion plate 90, and thereafter, it is radiated into an outside of the apparatus through the heat radiation fin 300. However, such the structure is advantageous, for example, in a case when the distance is far from the position where the CPU 2 00 as the heat-generation element is attached up to the position where the heat radiation fin can be attached.

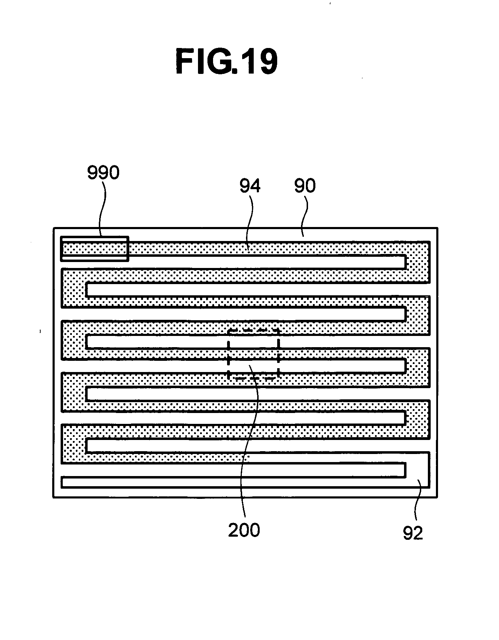

Further, Fig. 18 attached herewith shows an example, wherein the heat radiation fin 300 is attached upon the entire other side surface of the heat diffusion plate 90. With such the structure, it is possible to utilize the entire of the heat radiation fin 300, effectively, in spite of the fact that the area of the CPU 200 as the heat-generation element is small. Further, Fig. 19 shows a whole view seeing the heat diffusion plate 90 shown in Fig. 18 mentioned above, from an upper portion (the direction c indicted by an arrow in Fig. 10).

Although the explanation was made, mainly, only about the actuator, as a means for vibrating the operating liquid therewith, which is enclosed within the plural number of passages (i.e., the grooves) 91 formed within an inside thereof, for the purpose of transmitting (diffusing) the heat in the heat diffusion plate (i. e. , the heat spreader) 90, it is a type of heating the operating liquid 94 by means of the heater element mentioned above, thereby generating bubbles, however, the present invention should not be restricted only to such the embodiments as were mentioned in the above. Thus, for example, as one of those applying such the heat driving method therein, in the place of the embodiment mentioned above, further it is also possible of (1) applying a gas to be the operating liquid, in the place of the liquid mentioned above, and thereby generate vibration through repetitive expansion/condensation of the gas due to heating/cooling thereof. Further, in such a case, a fluid having large latent heat is applied as the gas to be enclosed within the heat diffusion plate, in the similar manner to that mentioned above. Alternatively, it is also possible (2) to use a bimetal in combination with the heating means, thereby giving vibration to the operating fluid mentioned above. Further, in the similar manner, it is also possible (3) to use a shape memory alloy in a part thereof, thereby giving vibration to the operating fluid mentioned above. Also, differing from such the heat driving method mentioned above, however it is also possible to utilize a piezoelectric element, such as so-called a piezo-element, etc., for example, thereby giving vibration to the operating fluid mentioned above.

As was fully explained in the above, according to the present invention mentioned above, since it is possible to transmit the heat to the heat radiation plate or the cooling jacket, which is generated in the heat-generation element having a small surface area thereof due to small-sizing and high integration of an element, such as the CPU, etc., for example, with high efficiency, with using the heat diffusion element/means mentioned above, thereby improving the cooling efficiency of the heat-generation element.

Also, in particular, with attaching the heat diffusion element/means onto the heat radiation plate or the cooling jacket, so as to the heat generated from the heat-generation element through the heat diffusion element/means to the heat radiation plate or the cooling jacket, the heat is transmitted to the coolant of a gas or a liquid in contact therewith, to be discharged into an outside, after being transported/diffused widely over an sufficient region of the cooling jacket. In this manner, due to the function of the heat diffusion element/means mentioned above, the area can be increased remarkably, for the heat generated in the heat-generation element to be transmitted to the heat radiation plate or the cooling jacket, thereby improving the cooling efficiency of the heat-generation element.

In particular, in a case where the heat diffusion element is attached on the cooling jacket, within an inside of which the liquid coolant flows, the heat can be transmitted into the liquid coolant flowing within the cooling jacket, with certainty, even at the position relatively far from the position contacting with the CPU, therefore, it is possible to fully use the cooling capacity by means of the cooling jacket. And, such the cooling system is suitable to be used, in particular, in the electronic apparatus, such as, the personal computers of so-called the desktop type and the notebook type, as well as, the server, etc.

The present inventionmay be embodied in other specific forms without departing from the spirit or essential feature or characteristics thereof. The present embodiment(s) is/are therefore to be considered in all respects as illustrative and not restrictive, the scope of the invention being indicated by the appended claims rather than by the forgoing description and range of equivalency of the claims are therefore to be embraces therein.

## Claims

1. A cooling system for an electronic apparatus, installing a semiconductor element (200) within a housing (100), which necessitates cooling for maintaining normal operation thereof, in a part of the housing (100), having:
a heat diffusion element being connected with the semiconductor element (200), thermally, wherein said heat diffusion element comprises:
a plate-like member (90) of heat conductive material, enclosing therein an operating liquid (94) having large latent heat; and
an actuator being provided in a part of the plate-like member (90), for vibrating said operating liquid (94) having large latent heat, wherein:
said heat diffusion element mounts said heat-generating semiconductor element (200) on one side surface, while transporting heat generated from said heat-generation semiconductor element (200) to other side surface of said heat diffusion element, thereby conducting heat transmission from said other side surface.

2. Cooling system for an electronic apparatus according to claim 1, **characterized in that** a heat radiation plate (90) is attached on the other side surface of said heat diffusion element.

3. Cooling system for an electronic apparatus according to claim 1 or 2, **characterized in that** a cooling jacket (50) is attached on the other side surface of said heat diffusion element, being thermally connected with said semiconductor element (200), thereby transmitting the heat generated therein to a liquid coolant (94) vibrating within an inside of said cooling jacket (50), so as to conduct the cooling upon said semiconductor.

4. Cooling system for an electronic apparatus according to any of claims 1 - 3, **characterized in that** the actuator for vibrating the operating liquid (94) filled within said heat diffusion element is made up with a heater wire (952) wound around periphery of two (2) pieces of supporting bodies.

5. Cooling system for an electronic apparatus according to claim 4, **characterized in that** said heater wire (952) is made from a nichrome wire.

6. Cooling system for an electronic apparatus, according to claim 4 or 5, **characterized in that** said actuator made up with the heater wire (952) wound around the periphery of said two (2) pieces supporting bodies is disposed within an inside of said plate-like member (90), so that it dips in said operating fluid (94) filled therein, near to said other surface thereof.

7. Cooling system for an electronic apparatus according to any of claims 4 - 6, **characterized in that** hydrophilic treatment is conducted on a portion, on a surface of interior wall of said one side surface in said plate-like member (90), in vicinity of said actuator.

8. An electronic apparatus, installing a heat-generating semiconductor element (200) within a housing thereof, which requires cooling for maintaining normal operation there, and having a cooling system, within said housing (100) or in a part thereof, comprising:
a cooling jacket (50), being thermally connected with the semiconductor element (200), for transmitting heat generated from to a liquid coolant (94) flowing within an inside thereof;
a radiator (60) for discharging the heat transmitted to the liquid coolant in said cooling jacket (50) into an outside; and
a circulation pump (70) for circulating said liquid coolant in a loop, including said cooling jacket (50) and said radiator (60) therein, wherein:
said cooling jacket (50) is in contact with a surface of said heat-generating semiconductor element (200) through a heat diffusion means for diffusing the heat generated from said heat-generating semiconductor element (200).

9. Electronic apparatus according to claim 8, **characterized in that** said heat diffusion means for diffusing the heat generated from said heat-generating semiconductor element (200) into said cooling jacket (50) comprises a hermetically sealed space for enclosing an operating fluid (94) having large latent heat to be vibrated within an inside thereof, and is made up with a plate-like member (90) having a surface shape being almost similar to that of said cooling jacket (50) and being superior in heat conductivity, wherein an actuator is provided in a portion thereof, for vibrating said operating fluid (94), while dipping in said operating fluid.

10. Electronic apparatus according to claim 9, **characterized in that** in a part of said hermetically sealed space of said heat diffusion means, into an inside of which is enclosed the operating fluid (94) having the large latent heat to be vibrated, is provided a buffer portion (92) for enclosing a gas therein.

11. Electronic apparatus according to claim 10, **characterized in that** said hermetically sealed space of said heat diffusion means, into an inside of which is enclosed the operating fluid (94) having the large latent heat to be vibrated, are formed in a plural number thereof and in parallel with each other, and also each of those is connected through said buffer portion (92), thereby forming a comb-like shape.

12. Electronic apparatus according to any of claims 9 - 11, **characterized in that** said heat diffusion means comprises a heating means provided in contact with a part of the operating fluid (94) enclosed within said hermetically sealed space, and said heating means is supplied with pulse-like electric power, thereby providing vibration to said operating fluid (94).

13. An electronic apparatus, installing a heat-generating semiconductor element (200) within a housing thereof, which requires cooling for maintaining normal operation there, and having a cooling system, within said housing (100) or in a part thereof, comprising:
a heat diffusion element, being connected with said semiconductor element (200), thermally; and
a heat radiator (60), wherein said heat diffusion element comprises:
a plate-like member (90) of heat conductive material, enclosing therein an operating liquid having large latent heat; and
an actuator being provided in a part of the plate-like member (90), for vibrating said operating liquid having large latent heat, whereby said heat diffusion element mounts said heat-generating semiconductor element (200) on one side surface, while diffusing heat generated from said heat-generating semiconductor element (200), thereby transmitting the heat to the other side surface of said heat diffusion element; and
said heat radiation plate (90) is attached on the other side surface of said heat diffusion element, and transmitting the heat generated from said heat-generating semiconductor element (200), which is transported through said heat diffusion element, from a surface thereof into an outside.
